Europäisches Patentamt

European Patent Office

Office européen des brevets

(11) Numéro de publication: **0 093 658**
**A1**

## (12) DEMANDE DE BREVET EUROPEEN

(21) Numéro de dépôt: 83400841.9

(22) Date de dépôt: 28.04.83

(51) Int. Cl.³: **G 01 R 31/30**
**G 06 F 11/24**

(30) Priorité: 30.04.82 FR 8207481

(43) Date de publication de la demande:
09.11.83 Bulletin 83/45

(84) Etats contractants désignés:
DE FR GB IT

(71) Demandeur: CII HONEYWELL BULL
94 Avenue Gambetta
F-75990 Paris Cedex 20(FR)

(72) Inventeur: Dussine, Roger
94 avenue Gambetta
F-75960 Paris Cedex 20(FR)

(72) Inventeur: Kiefer, Lucien
94 avenue Gambetta
F-75960 Paris Cedex 20(FR)

(74) Mandataire: Denis, Hervé et al,
COMPAGNIE INTERNATIONALE POUR
L'IMFORMATIQUE CII-HONEYWELL BULL 94, avenue
Gambetta
F-75960 Paris Cedex 20(FR)

(54) Appareil de test aux marges et machine utilisant cet appareil.

(57) L'invention concerne un appareil de test aux marges (10) couplé à un ensemble de cartes de circuits imprimés (14) alimentées en énergie électrique notamment par un bus (20) via un fil (24).

Selon l'invention, le couplage est magnétique. Ainsi, la tension de test aux marges produite par l'appareil (10) est appliquée au fil (24) par l'intermédiaire d'un coupleur magnétique (26) sous la forme d'une pince de courant ou d'un tore (28) entourant fixement le fil (24) et comportant un primaire (30) recevant la tension de test.

L'invention s'applique notamment au test aux marges des machines de traitement de l'information.

FIG. 1

"APPAREIL DE TEST AUX MARGES ET MACHINE UTILISANT CET APPAREIL"

L'invention se rapporte à un appareil de test aux marges et à une machine utilisant cet appareil.

Le test aux marges est la technique suivant laquelle certaines conditions de fonctionnement de circuits électriques, telles qu'une tension d'alimentation ou une fréquence d'horloge, sont modifiées autour de leur valeur nominale pour déterminer et localiser les éléments de circuit qui commencent à présenter des défauts. L'invention s'applique donc généralement à tout ensemble de circuits électriques, et plus particulièrement aux machines de traitement de l'information.

Les machines de traitement de l'information sont constituées par des armoires contenant un assemblage de cartes de circuits imprimés porteuses de plusieurs supports d'interconnexion de dispositifs à circuits intégrés. Les cartes de circuits imprimés sont chacune reliées par des fils d'alimentation à des barres omnibus distribuant respectivement différentes tensions d'alimentation en énergie prédéterminées.

La technique antérieure de test aux marges d'une carte de circuits imprimés consiste essentiellement à déconnecter des fils d'alimentation des cartes de circuits imprimés pour les brancher sur un générateur de test aux marges. Ce générateur est pourvu d'une commande réglable de la tension d'alimentation. Cette technique présente de nombreux inconvénients. En particulier, la manipulation pour la connexion et la déconnexion peut elle-même être génératrice de pannes tandis que la déconnexion des fils d'alimentation nécessite l'arrêt de la machine, de sorte que se posent tous les problèmes bien connus de la remise en route de la machine pour obtenir les conditions normales de fonctionnement.

Pour pallier ces inconvénients, la tendance actuelle est de centraliser l'appareil de test aux marges dans les machines de traitement de l'information. Cet appareil ainsi centralisé doit donc détecter et localiser les défauts au niveau de l'ensemble des nombreuses cartes de circuits imprimés qui composent les machines de traitement de l'information de moyennes et hautes gammes. Bien que cette centralisation a l'avantage d'offrir une vue d'ensemble du fonctionnement de la machine, elle a l'inconvénient de mettre en oeuvre des programmes de test de nature compliquée, à déroulement long, et pour obtenir finallement des résultats non exhaustifs.

Par ailleurs, il est à noter que la technique antérieure de test aux marges n'est réalisable qu'en agissant sur des conditions de fonctionnement indépendantes des signaux logiques, à savoir une tension d'alimentation ou une fréquence. Il serait pourtant souhaitable de pouvoir pratiquer, tout au moins pour certains circuits, un test aux marges relatif aux signaux logiques, en y appliquant par exemple des parasites de haute fréquence pour vérifier leur immunité à ces parasites.

L'invention remédie à tous ces inconvénients de la technique antérieure.

Selon l'invention, un appareil de test aux marges du type couplé à un ensemble de circuits électriques est caractérisé en ce que ledit couplage est magnétique.

Ainsi, on injecte par induction magnétique le signal de test, sans avoir à déconnecter les circuits. Le fil choisi peut être un fil d'alimentation, ou un fil de signaux logiques dans lequel des parasites de haute fréquence seront injectés pour vérifier l'immunité des circuits vis-à-vis de ces parasites.

Les caractéristiques et avantages de l'invention ressortiront de la description qui suit, faite en référence aux dessins annexés.

Dans les dessins :

- la figure 1 est une vue synoptique fragmentaire d'une machine de traitement de l'information couplée avec un appareil extérieur de test aux marges conforme à l'invention ;

- la figure 2 illustre de manière schématique un exemple de réalisation d'un appareil de test aux marges conforme à l'invention ;

- les figures 3a, 3b et 3c illustrent chacune des formes d'ondes prélevées en des mêmes points donnés (A-D) de l'appareil de test aux marges représenté sur la figure 2, afin d'expliquer le fonctionnement de cet appareil pour respectivement trois cas de fonctionnement ; et

- la figure 4 est une vue synoptique fragmentaire d'une machine de traitement de l'information incluant une variante de réalisation d'un appareil centralisé de test aux marges conforme à l'invention.

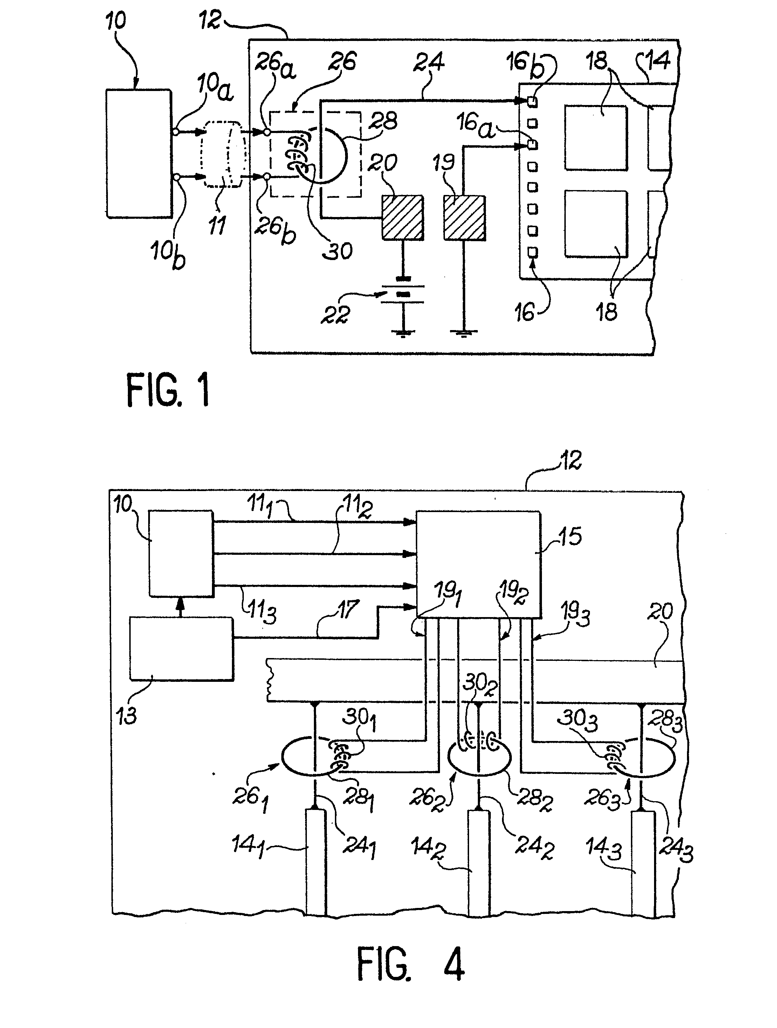

La figure 1 illustre un appareil de test aux marges (10) couplé extérieurement à une machine de traitement de l'information (12) dans laquelle ne sont représentés que les éléments essentiels concernés par l'invention. Ainsi, la machine (12) contient plusieurs cartes de circuits imprimés (14) pourvues de bornes périphériques d'entrée-sortie (16) reliées par un réseau de conducteurs (non représenté) à des supports (18) d'interconnexion de dispositifs à circuits intégrés. Des bornes (16a, 16b) de la carte (14) sont reliées respectivement à deux barres omnibus (19, 20) représentatives de deux tensions d'alimentation différentes. Dans l'exemple illustré, la barre omnibus (19) distribue le potentiel de masse tandis que la barre (20) distribue à chaque carte de circuits imprimés (14), par l'intermédiaire d'un fil d'alimentation (24), une tension fournie par une source d'alimentation en énergie (22).

Conformément à l'invention, le fil (24) est isolé matériellement de manière à recevoir un coupleur magnétique (26) dont les bornes d'entrée (26a, 26b) sont connectées aux bornes de sortie respectives (10a, 10b) de l'appareil de test aux marges (10) par l'intermédiaire d'un câble (11). Le coupleur a avantageusement la forme d'une pince de courant quand l'appareil (10) est extérieur à la machine (12). Une telle pince forme avec le fil (24) (comme représenté à l'état fermé à la figure 1) un transformateur, dont une mâchoire inclut le primaire (30) connecté aux deux bornes d'entrée (26a, 26b) et enroulé sur une partie d'un noyau magnétique (28) et dont l'autre mâchoire renferme l'autre partie du noyau magnétique de telle sorte que celui-ci constitue un circuit magnétique fermé autour du fil (24) lorsque la pince est en service.

Le couplage étant magnétique, il est évidemment préférable de travailler avec de faibles énergies. En technologie CML, le fil sur lequel s'appliquera l'appareil sera donc celui concernant la tension de référence (-0,27 Volt) mettant en oeuvre de faibles intensités (de l'ordre de 1 ampère par exemple).

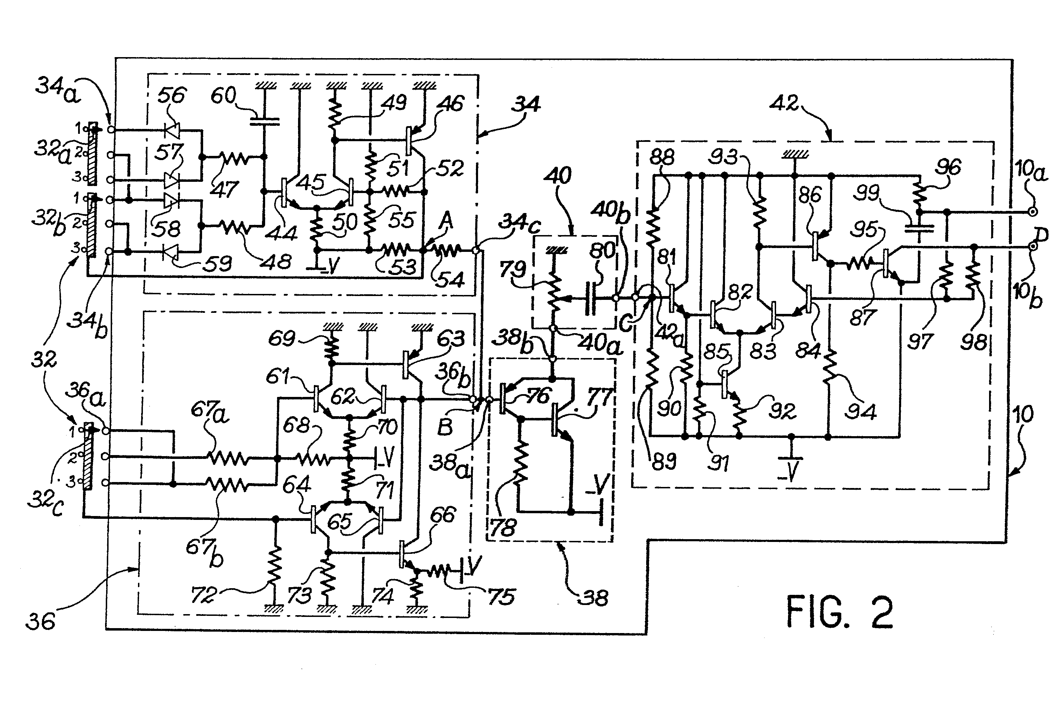

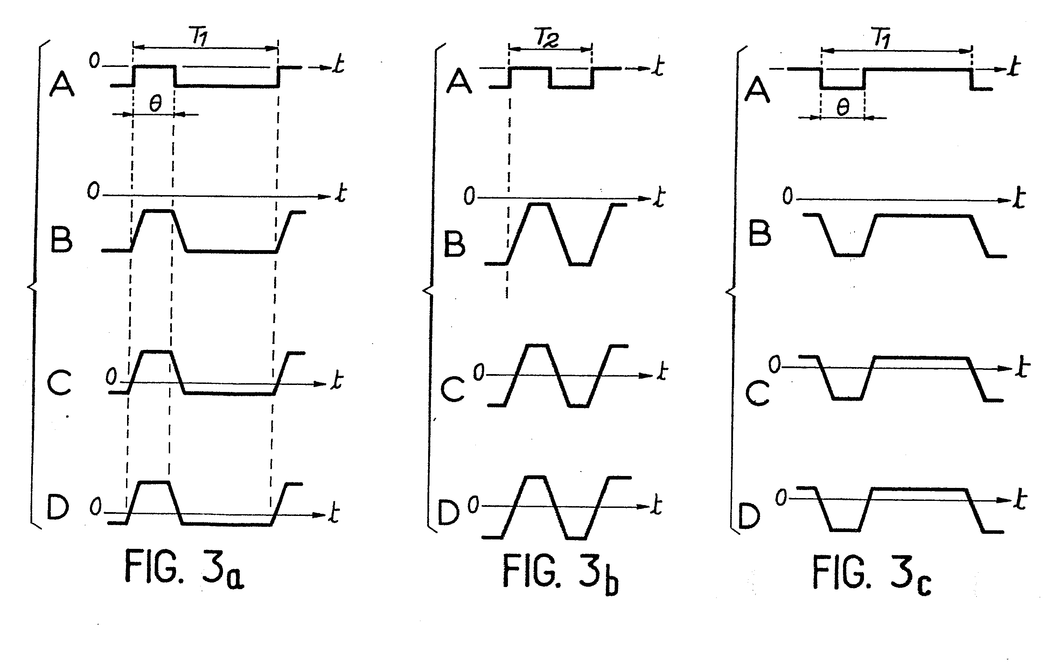

Un exemple de réalisation d'un appareil de test aux marges conforme à l'invention est illustré schématiquement à la figure 2. Selon cet exemple, l'appareil (10) pourvu de ses deux bornes de sortie (10a, 10b) est couplé à un organe de commande (32) servant à définir plusieurs modes de fonctionnement de l'appareil (10). Trois modes typiques de fonctionnement ont été considérés dans l'exemple illustré aux figures 2 et 3, en correspondance avec des positions respectives 1, 2, 3 de l'organe (32). Ces trois positions se trouvent ensemble sur chacun des trois éléments de commutation (32a, 32b, 32c) qui constituent l'organe de commande (32).

L'appareil (10) comprend un oscillateur (34), un dispositif de mise en forme de signaux (36), un abaisseur d'impédance (38), un dispositif de réglage (40), et un amplificateur de sortie (42), tous ces éléments étant représentés sous forme de blocs par des traits tiretés. L'oscillateur (34) comprend trois bornes de contact (34a) en correspondance avec les positions 1, 2 et 3 de l'élément de commutation (32a) et trois bornes de contact (34b) en correspondance avec les positions 1, 2 et 3 de l'élément de commutation (32b). L'oscillateur (34) se compose de trois transistors (44, 45, 46), de neuf résistances (47-55), de quatre diodes (56-59) et d'un condensateur (60). Les diodes (56, 57) sont montées tête-bêche entre les bornes (34a - positions 1 et 3) et la base du transistor (44) via la résistance (47). Il en est de même pour les diodes (58, 59), les bornes (34b - positions 1 et 3) et la résistance (48). La borne (34a - position 2) est connectée à la borne (34b - position 1), tandis que les bornes (34b - positions 2 et 3) sont interconnectées. La base du transistor (44) est en liaison avec l'anode des diodes (56, 59) et la cathode des diodes (57, 58), tandis qu'elle est mise à la masse via le condensateur (60). Le collecteur du transistor (44) et l'émetteur du transistor (46) sont directement connectés à la masse. Le collecteur du transistor (45) est connecté directement à la base du transistor (46) tandis qu'il est mis à la masse via la résistance (49). Les émetteurs des transistors (44, 45) sont interconnectés et reliés à un potentiel -V par la résistance (50). La base du transistor (45) est reliée à la masse par la résistance (51) et au potentiel -V par la résistance (55), ainsi qu'au collecteur du transistor (46) par la résistance (52). Les éléments de commutation (32a) et (32b) sont connectés à un point commun (A), correspondant au collecteur du transistor (46) et relié au potentiel -V par la résistance (53). La borne de sortie (34c) de l'oscillateur (34) est reliée au point (A) par la résistance (54).

Le dispositif de mise en forme de signaux (36) comprend trois bornes de contact (36a) en relation avec les positions 1, 2 et 3 de l'élément de commutation (32c), ainsi qu'une borne de sortie (36b). Le dispositif (36) se compose de six transistors (61-66) et de dix résistances (67a, 67b, 68-75). Les transistors (61, 62, 63) et (64, 65, 66) forment un montage sensiblement symétrique. Les émetteurs des transistors (61, 62) et (64, 65) sont connectés au potentiel -V respectivement par les résistances (70, 71). Les collecteurs des transistors (61) et (64) sont respectivement connectés directement à la base des transistors (63, 66) et mis à la masse par l'intermédiaire des résistances (69) et (73). Les collecteurs des transistors (62) et (65) sont directement appliqués à la masse ainsi que l'émetteur du transistor (63). L'émetteur du transistor (66) est relié à la masse par la résistance (74) et au potentiel -V par la résistance (75). La base du transistor (61) est reliée au potentiel -V par la résistance (68) et aux bornes (36a - positions 2 et 3) respectivement par les résistances (67a, 67b). Les bornes (36a - positions 1 et 3) sont interconnectées. L'élément de commutation (32c) est connecté à la base du transistor (64), qui est mise à la masse par l'intermédiaire de la résistance (72). La borne de sortie (36b) du dispositif de mise en forme (36) est constituée par l'interconnexion des collecteurs des transistors (63) et (66) et des bases des transistors (62) et (65).

L'abaisseur d'impédance (38) a une borne d'entrée (38a), constituant un point (B) du circuit électrique de l'appareil (10) et étant connectée aux bornes de sortie (34c) et (36b) de l'oscillateur (34) et du dispositif de mise en forme de signaux (36), et une borne de sortie (38b). L'abaisseur d'impédance (38) se compose de deux transistors (76, 77) et d'une résistance (78) ensemble montés pour former un montage à émetteur-suiveur. Ainsi, le transistor (76) a sa base connectée à la borne d'entrée (38a), son émetteur connecté au collecteur du transistor (77) ainsi qu'à la borne de sortie (38b), et son collecteur connecté à la base du transistor (77) ainsi qu'au potentiel -V via la résistance (78). L'émetteur du transistor (77) est connecté également au potentiel -V.

Le dispositif de réglage (40) présente une borne d'entrée (40a) connectée à la borne de sortie (38b) de l'abaisseur d'impédance (38), et une borne de sortie (40b). Il se compose d'un potentiomètre (79) et d'un condensateur (80), la résistance du potentiomètre étant connectée entre la masse et la borne (40a) et son curseur étant relié à la borne de sortie (40b) via le condensateur (80). La borne de sortie (40b) constitue un point (C) du circuit électrique de l'appareil (10).

L'amplificateur de sortie (42) présente une borne d'entrée (42a) et deux bornes de sortie constituant les bornes de sortie (10a, 10b) de l'appareil (10). Il se compose de sept transistors (81-87), de onze résistances (88-98) et d'un condensateur (99). Les transistors (82, 83) forment un amplificateur différentiel alimenté par une source de courant formée par le transistor (85) et attaqué par les transistors (81, 84). La tension prélevée de cet amplificateur différentiel par le transistor (86) est amplifiée par le transistor (87). Plus précisément, les collecteurs des transistors (81, 82, 84) ainsi que l'émetteur du transistor (86) et la base du transistor (85) sont connectés directement à la masse. Le collecteur du transistor (83) est connecté à la base du transistor (86) et est mis à la masse via la résistance (93). Les émetteurs des transistors (82) et (83) sont interconnectés avec le collecteur du transistor (85), dont l'émetteur et la base sont reliés au potentiel -V via les résistances (92) et (91). La borne d'entrée (42a) est, reliée respectivement à la masse par la résistance (88), au potentiel -V par la résistance (89), et directement à la base du transistor (81). L'émetteur du transistor (81) attaque directement la base du transistor (82), tout en étant mis au potentiel -V via la résistance (90). Le transistor (84) a son émetteur connecté à la base du transistor (83) et a sa base reliée respectivement aux bornes de sortie (10a, 10b) via les résistances (97, 98). Le collecteur du transistor (86) est relié au potentiel -V par la résistance (94) et à la base du transistor (87) par la résistance (95). Le collecteur du transistor (87) est connecté à la borne (10b), tandis que son émetteur est connecté directement au potentiel -V et est relié à la borne (10a) par le condensateur (99), dont la plaque commune avec la borne (10a) est mise à la masse via la résistance (96). La borne (10b) constitue un point remarquable référencé (D) du circuit électrique de l'appareil (10).

Le fonctionnement de l'appareil (10) représenté sur la figure 2 va maintenant être expliqué en relation avec les figures 3a-3c ainsi qu'avec l'exemple de la figure 1, où l'on considerera que la machine (12) est de technologie (CML) et que la source d'alimentation (20) représente la tension de référence ($V_{ref}$ = -0,27Volt). Dans chacune des figures 3a-3c, les formes d'onde (A-D) correspondent à celles prélevées aux points (A-D) du circuit électrique de l'appareil (10) représenté sur la figure 2.

En bref, l'oscillateur (34) forme une tension alternative mise en forme par le dispositif (36), ajustée en amplitude grâce à l'abaisseur d'impédance (38) et au dispositif de réglage (40), amplifiée en tension et en courant par l'amplificateur de sortie (42) et appliquée au coupleur magnétique (26) par l'intermédiaire des bornes de sortie (10a, 10b) de l'appareil (10). Les positions 1, 2, 3 des trois éléments de commutation de l'organe de commande (32) correspondent respectivement à trois modes de fonctionnement de l'appareil (10) : les positions 1 et 3 correspondent à l'application au coupleur (26) de signaux alternatifs trapezoïdaux de polarités inversées selon que les positions sont 1 et 3, tandis que la position 2 correspond à un signal de sortie alternatif symétrique. En d'autres termes, les positions 1 et 3 sont destinées à accentuer le test dans une marge par rapport à l'autre, alors que la position 2 correspond à un test aux deux marges. Plus précisément, en référence à la figure 3a on voit que la tension au point (A) de l'oscillateur (34) est un signal rectangulaire négatif, par exemple de période $T_1 = 500us$ et de rapport cyclique de 1/5 (d'où 0 = 100us). Au point (B), le signal a la forme désirée, correspondant à un signal trapézoïdal, dont les fronts de montée et de descente sont ajustés en fonction de la fréquence de l'oscillateur (34) et des caractéristiques du coupleur magnétique (26), afin de limiter les pointes de courant dans ce dernier. Pour la mise en forme du signal au point (A), on voit que le dispositif (36) pourrait être remplacé par deux diodes montées tête-bêche, à la condition bien sûr que les signaux à limiter aient une faible amplitude. Le signal (A) tel que mis en forme au point (B) a son amplitude au point (C) ajustée grâce à l'abaisseur d'impédance (38) et au dispositif de réglage (40).
L'abaisseur d'impédance (38) est constitué par un
émetteur-suiveur classique, tandis que le potentiomètre
(79) permet de régler l'amplitude du signal de test.
Evidemment, avec une autre structure possible du
dispositif de mise en forme de signaux (36) ou du dispositif de réglage (40), l'abaisseur d'impédance aurait pu
être supprimé. Au point (C) on voit à la figure 3a que le
signal est un signal trapézoïdal alternatif disymétrique,
par exemple de 250mV d'amplitude positive et de 60mV
d'amplitude négative. Ce signal est amplifié pour qu'au
point (D) il ait par exemple une amplitude positive de 2V
et amplitude négative de 0,5V. Pour un coupleur magnétique
(26) dont le bobinage (30) et le fil (24) formeraient
respectivement le primaire et le secondaire d'un
transformateur de rapport 1/20 par exemple, le signal
injecté dans le fil (24) correspondrait ainsi à +0,1Volt.

Pour un test à la marge négative, le signal sera inversé
en disposant les trois éléments de commutation de l'organe
de commande (32) sur la position (3), auquel cas les
signaux correspondent à ceux représentés sur la figure 3c.

Pour un test simultané aux deux marges, les trois éléments
de commutation de l'organe de commande (32) seront
disposés sur la position 2, auquel cas les signaux seront
par exemple ceux illustrés à la figure 3b. La fréquence
choisie dans ce cas est un peu plus élevée, 5kHz par
exemple (T2 = 200us), pour éviter qu'un courant
magnétisant trop important ne s'installe dans le coupleur
(26). Le signal de sortie est un signal trapézoïdal
symétrique, d'amplitudes valant chacune 2 Volts par
exemple.

De même l'appareil de test (10) pourrait être centralisé
dans la machine (12). Dans ce cas, son action auprès de chaque carte (14) pourrait se faire comme représenté sur la figure 4. A la figure 4, l'appareil de test (10) est incorporé à la machine (12) et est associé avec un dispositif de traitement de programme de test (13) de toutes les cartes de circuits imprimés (14) de la machine. Trois cartes ($14_1$, $14_2$, $14_3$) ont été illustrés à titre d'exemple. Selon l'invention, les fils d'alimentation correspondants ($24_1$, $24_2$, $24_3$) sont isolés matériellement et sont entourés respectivement par des tores ($28_1$, $28_2$, $28_3$) sur lesquels sont enroulés les bobinages ($30_1$, $30_2$, $30_3$). L'appareil de test (10) a plusieurs sorties reliées par des câbles ($11_1$, $11_2$, $11_3$) à un bloc de commutation (15) commandé par une sortie (17) du dispositif de traitement de programme de test (13). Le bloc de commutation (15) a des sorties reliées par des câbles ($19_1$, $19_2$, $19_3$) aux bobinages respectifs ($30_1$, $30_2$, $30_3$) des coupleurs magnétiques ($26_1$, $26_2$, $26_3$). Ainsi, le déroulement du programme de test centralisé dans le dispositif (13) permet de détecter et localiser dans toute la machine le ou les blocs fonctionnels qui commencent à présenter des défauts. Dès lors, grâce à l'invention, un test "fin" peut être entrepris au niveau de chaque carte du bloc fonctionnel détecté afin de localiser la ou les cartes à réparer ou à remplacer. On comprendra par conséquent que, d'une manière générale, le nombre de câbles (19) peut être différent du nombre de câbles (11) et que dans le cas particulier décrit en référence aux figures précédentes, les trois câbles ($11_1$, $11_2$, $11_3$) seront avantageusement porteurs de signaux respectifs tels que ceux illustrés aux figures 3a, 3b et 3c, ces signaux étant ensuite appliqués sélectivement aux divers coupleurs ($26_1$, ..., $26_n$) par le bloc de commutation (15) sous la commande du dispositif de traitement de programme de test centralisé (13).

Le test aux marges se fait donc par un couplage magnétique à un endroit désiré, pourvu que le fil (24) correspondant soit accessible isolément. Ce fil (24) peut d'une manière générale être un fil d'alimentation ou un fil de signaux logiques. Pour ce dernier cas, l'appareil (10) correspondra à un générateur de parasites de haute fréquence.

REVENDICATIONS

1. Appareil de test aux marges (10) du type couplé à un ensemble de circuits électriques (14), caractérisé en ce que ledit couplage est magnétique (26).

2. Appareil selon la revendication 1, caractérisé en ce que le couplage s'applique à un fil d'alimentation (24).

3. Appareil selon la revendication 1, caractérisé en ce qu'il forme un générateur de parasites de haute fréquence et en ce que le couplage s'applique à un fil de signaux.

4. Appareil selon la revendication 1 ou 2, caractérisé en ce que le générateur comprend un oscillateur (34), un dispositif de mise en forme (36), un dispositif de réglage d'amplitude (40), un amplificateur de sortie (42) et un coupleur magnétique (26).

5. Appareil selon l'une quelconque des revendications 1 à 4, caractérisé en ce qu'il fournit un signal pour un test dans au moins une marge (figures 3a, 3b, 3c).

6. Appareil selon l'une quelconque des revendications 1 à 5, caractérisé en ce que le coupleur (26) est une pince de courant pouvant entourer amoviblement un fil (24).

7. Appareil selon l'une des revendications 1 à 5, caractérisé en ce que le coupleur (26) comprend un tore (28) monté fixement autour d'un fil et supportant un bobinage (30) destiné à être relié audit appareil de test (10).

8. Machine (12) pour l'utilisation d'un appareil de test aux marges (10) selon l'une quelconque des revendications 1 à 7, du type comprenant un ensemble de cartes de circuits imprimés comportant chacune au moins un fil de test, caractérisée en ce que ledit fil (24) comporte un tore (28) supportant un bobinage (30) relié audit appareil de test aux marges.

9. Machine selon la revendication 8, caractérisée en ce que ledit fil de test est un fil d'alimentation.

10. Machine selon la revendication 8, caractérisée en ce que ledit fil est un fil de signaux.

11. Machine selon l'une quelconque des revendications 8 à 10, caractérisée en ce que chaque bobinage (30) est connecté à un bloc de commutation (15) recevant au moins un signal de sortie dudit appareil de test (10).

12. Machine selon la revendication 11, caractérisée en ce que ledit signal de sortie correspond à un test dans au moins une marge.

FIG. 1

FIG. 4

FIG. 2

2/3

0093658

FIG. 3ₐ

FIG. 3_b

FIG. 3_c

0093658

Office européen
des brevets

**RAPPORT DE RECHERCHE EUROPEENNE**

EP 83 40 0841

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| A | US-A-3 820 077 (F. GIEBLER et al.)<br>* Abrégé * | 1,8 | G 01 R 31/30<br>G 06 F 11/24 |
| | --- | | |
| A | US-A-3 714 556 (F.A. RISKY)<br>* Figure 2; abrégé * | 1,8 | |
| | --- | | |
| A | US-A-3 679 970 (H.M. WINTERS et al.)<br>* Figure 1; abrégé * | 1,8 | |
| | ----- | | |

|  |
|---|
| DOMAINES TECHNIQUES RECHERCHES (Int. Cl. ³) |
| G 01 R<br>G 06 F |

Le présent rapport de recherche a été établi pour toutes les revendications

| Lieu de la recherche<br>LA HAYE | Date d'achèvement de la recherche<br>11-07-1983 | Examinateur<br>MIELKE W |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

 

& : membre de la même famille, document correspondant

OEB Form 1503. 03.82